# EUROPÄISCHE PATENTSCHRIFT

(11) **EP 1 316 143 B1**
(45) Veröffentlichungstag und Bekanntmachung des Hinweises auf die Patenterteilung: **26.01.2005**
(21) Anmeldenummer: 01967069.4
(22) Anmeldetag: 06.09.2001
(51) Int. Cl.: H03D 1/00

(54) **EMPFÄNGERSCHALTUNG, INSBESONDERE FÜR DEN MOBILFUNK**
RECEIVER CIRCUIT ESPECIALLY FOR MOBILE RADIOTELEPHONY
CIRCUIT RECEPTEUR, EN PARTICULIER POUR LA TELEPHONIE MOBILE

(30) Priorität: 08.09.2000 DE 10044449
(43) Veröffentlichungstag der Anmeldung: 04.06.2003
(73) Patentinhaber: Infineon Technologies AG, 81669 München (DE)
(72) Erfinder: HAMMES, Markus, 46539 Dinslaken (DE); HEINEN, Stefan, 47802 Krefeld (DE); VAN WAASEN, Stefan, 47178 Duisburg (DE); HANKE, André, 40468 Düsseldorf (DE); MEHRGARDT, Sönke, 82041 Deisenhofen (DE); WAGNER, Elmar, 47269 Duisburg (DE)
(74) Vertreter: Epping Hermann & Fischer
(86) Internationale Anmeldenummer: PCT/DE2001/003425
(87) Internationale Veröffentlichungsnummer: WO 2002/021680

(56) Entgegenhaltungen:
- EP-A- 0 797 292
- EP-A- 0 948 128
- US-A- 5 376 894
- US-A- 5 521 548
- US-A- 5 548 831
- US-A- 5 715 529
- US-A- 5 724 001

## Beschreibung

Die Erfindung betrifft eine Empfängerschaltung, insbesondere für den Mobilfunk.

Zum Empfang hochfrequenter, modulierter Signale werden in Mobilfunk-Anwendungen und Schnurlostelefonen normalerweise Superheterodyn-Empfangsarchitekturen eingesetzt. Diese weisen eine verhältnismäßig hohe Zwischenfrequenzebene auf. Die superheterodyne Architektur hat jedoch den Nachteil eines großen Flächenbedarfs und der verhältnismäßig schlechten Integrationsmöglichkeiten.

Zur Verbesserung der monolithischen Integration von Mobilfunkempfängern besteht ein Trend zu Funkempfängern mit geringer Zwischenfrequenz oder der Zwischenfrequenz Null.

Beispielsweise aus dem Aufsatz "A Low-IF, Polyphase Receiver for DECT, B.J. Minnis et al, IEEE International Symposium on Circuits and Systems, May 28 - 31, 2000, Geneva, Switzerland" ist ein Funkempfänger für den DECT-(Digital Enhanced Cordless Telecommunication-) Standard bekannt. Dieser weist eine Zwischenfrequenz von 864 kHz auf. Derartige, analog aufgebaute Empfänger-Architekturen haben jedoch den Nachteil, daß die zur Realisierung der Empfängerschaltungen erforderlichen analogen Bauelemente aufgrund von Temperatureinflüssen und fertigungsbedingten Streuungen stark toleranzbehaftet sind. Eine gewünschte, hohe Empfindlichkeit des Mobilfunkempfängers ist folglich nicht oder nur mit großem Aufwand möglich.

Eine ähnliche Empfängerschaltung ist in der US 5 715529 beschrieben.

Es sind weiterhin Empfänger-Architekturen bekannt, welche nach dem Empfänger-Frontend auf der Zwischenfrequenzebene Analog-Digital-Wandler einsetzen, um eine digitale Weiterverarbeitung der Empfangssignale zu ermöglichen. An diese Analog-Digital-Wandler werden hohe Anforderungen an Auflösung und Präzision gestellt, so daß diese einen großen Chipflächenbedarf sowie eine hohe Stromaufnahme aufweisen. Diese Nachteile stehen jedoch den im Mobilfunk geltenden Forderungen nach immer kleineren Abmessungen, geringerem Gewicht sowie längerer Batterielebensdauer entgegen.

In dem Dokument US 5,376,894 ist ein PSK-Empfänger mit heterodyner Architektur angegeben. Dieser weist einen mehrstufigen Abwärtsmischer auf, dem ein Limiter, eine AbtastEinrichtung und ein Demodulator nachgeschaltet sind.

Aufgabe der vorliegenden Erfindung ist es, eine Empfängerschaltung (Receiver), insbesondere für den Mobilfunk, anzugeben, welche mit geringer Stromaufnahme bei geringem Chipflächenbedarf und hoher Empfindlichkeit aufgebaut werden kann.

Erfindungsgemäß wird die Aufgabe durch eine Empfängerschaltung zur Demodulation eines Hochfrequenzsignals, insbesondere für den Mobilfunk, nach Anspruch 1 gelöst. Diese weist eine erste Mischerstufe, der an einem ersten Eingang das zu demodulierende Hochfrequenzsignal und an einem zweiten Eingang ein komplexes Trägersignal zuführbar ist und an deren Ausgang ein komplexes Zwischenfrequenzsignal ableitbar ist, einen begrenzenden Verstärker, der an den Ausgang der ersten Mischerstufe angekoppelt ist und an dessen Ausgang ein aus dem Zwischenfrequenzsignal abgeleitetes, wertdiskretes Signal vorliegt, eine Abtasteinrichtung, welche an den Ausgang des begrenzenden Verstärkers angeschlossen ist, wobei zwischen erster Mischerstufe und begrenzendem Verstärker ein Kanalfilter angeordnet ist, welches als Polyphasenfilter ausgebildet ist, und eine digitale Demodulationseinheit auf, die der Abtasteinrichtung nachgeschaltet ist und die an ihrem Ausgang ein demoduliertes Signal bereitstellt.

Ausgangsseitig an dem begrenzenden Verstärker (Limiter) liegt das Eingangssignal, welches in seine Quadraturkomponenten zerlegt ist, als wertdiskretes, aber zeitkontinuierliches Signal vor. Der begrenzende Verstärker ordnet dem Signal logische Zustände, beispielsweise 0 oder 1, zu. Im sich anschließenden digitalen Demodulator wird das wertdiskrete, zeitkontinuierliche Eingangssignal demoduliert, so daß am Ausgang des digitalen Demodulators ein zeit- und wertdiskretes Signal vorliegt. Zur Zeitdiskretisierung ist dabei eine Abtasteinrichtung vorgesehen, welche das Eingangssignal mit einer Abtastfrequenz abtastet.

Das Eingangssignal kann ein FSK-(frequency shift keying-) oder GMSK- (gaussian minimum shift keying-) moduliertes Signal sein.

Die Empfängerschaltung weist den Vorteil auf, daß sie einfach aufgebaut ist, mit geringem Chipflächenbedarf realisierbar und energiesparend betreibbar ist. Zudem weist die Empfängerschaltung mit digitaler Demodulation eine hohe Empfindlichkeit und geringe Toleranzen auf.

Die erste Mischerstufe, welche das Hochfrequenzeingangssignal in ein Zwischenfrequenzsignal heruntersetzt, kann hierfür Ringmischer oder aktive, doppelt balancierte Mischer aufweisen. Die erste Mischerstufe kann je einen Mischer für die Inphase- und die Quadratur-Komponente aufweisen, wobei das Trägersignal dem Inphase-Mischer unverändert und dem Quadratur-Komponenten-Mischer um 90° phasenverschoben zuführbar ist.

Gemäß vorliegendem Prinzip ist zwischen erster Mischerstufe und dem begrenzenden Verstärker ein als Polyphasenfilter ausgebildetes Kanalfilter geschaltet.

Hierdurch kann mit Vorteil auf Bandpaß-Filter vor dem ersten Mischer, der als Abwärts-Konverter ausgebildet ist, zur Kanalselektion verzichtet werden. Zudem bietet vorliegende Anordnung aufgrund der komplexwertigen Signalverarbeitung eine höhere Genauigkeit, da für eine Signal-Interpolation mehr Stützstellen zur Verfügung stehen.

In einer vorteilhaften Ausführungsform der vorliegenden Erfindung ist die Trägerfrequenz des Zwischenfrequenzsignals kleiner oder gleich 20 MHz. Die Trägerfrequenz des Zwischenfrequenzsignals ist dabei größer Null Hertz.

Erfindungsgemäß kann die digitale Demodulationseinheit ein Bandpaßfilter mit nachgeschaltetem digitalem Demodulator aufweisen. Dieses Bandpaßfilter erfüllt die Aufgabe, höhere Harmonische des Nutzsignals zu unterdrücken.

In diesem Fall ist das Bandpaßfilter als Polyphasenfilter realisiert.

Dabei list der digitale Demodulator ein Quadrikorrelator.

Gemäß einer Alternative der vorliegenden Erfindung weist die digitale Demodulationseinheit eine digitale Mischerstufe mit nachgeschaltetem Tiefpaßfilter und digitalem Demodulator auf. Der digitale Mischer erfüllt dabei die Aufgabe, durch Mischen des Eingangssignals mit dessen Mittenfrequenz seiner Trägerfrequenz die Trägerfrequenz des Eingangssignals zu entfernen. Am Ausgang der digitalen Demodulationseinheit weist das in I- und Q-Komponenten vorliegende Eingangssignal demnach eine Trägerfrequenz von 0 Hz auf. Das Tiefpaßfilter kann Mittel zur Reduzierung der Taktrate des zu filternden Signals aufweisen.

Weitere Einzelheiten der vorliegenden Erfindung sind im abhängigen Anspruch 2 angegeben.

Die Erfindung wird nachfolgend an mehreren Ausführungsbeispielen anhand der Zeichnungen näher erläutert. Es zeigen:
- Figur 1: die Architektur einer beispielhaften erfindungsgemäßen Empfängerschaltung anhand eines Blockschaltbildes;
- Figur 2: ein erstes Ausführungsbeispiel des digitalen Demodulators von Figur 1; und
- Figur 3: ein zweiten Ausführungsbeispiel des digitalen Demodulators von Figur 1.

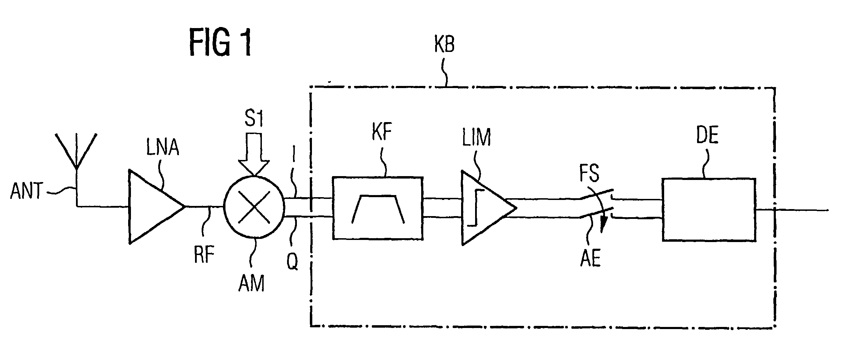

Figur 1 zeigt einen Funkempfänger mit einer ersten Mischerstufe AM, der an ihrem ersten Eingang ein zu demodulierendes Hochfrequenzempfangssignal RF zuführbar ist, und an deren zweitem Eingang ein komplexes Trägersignal S1 zugeführt wird. Das Hochfrequenzempfangssignal RF koppelt dabei in eine Antenne ANT ein und wird in einem rauscharmen Vorverstärker LNA vor der Zuführung zur ersten Mischerstufe AM verstärkt. Das komplexe Trägersignal S1 weist eine Kosinus- und eine dazu um 90° phasenverschobene Sinuskomponente auf, welche der ersten Mischerstufe derart zugeführt sind, daß sich am Ausgang ein Zwischenfrequenzsignal I, Q ergibt, welches eine geringe Zwischenfrequenz aufweist. Am Ausgang der ersten Mischerstufe AM, welche als analoge Mischerstufe ausgeführt ist, ist ein Kanalfilter KF angeschlossen, welches zum Herausfiltern unerwünschter Spiegelfrequenzen dienen kann. An das Kanalfilter KF schließt sich in der weiteren Signalverarbeitung ein begrenzender Verstärker LIM in einer Limiter-Stufe an. Dieser verstärkt und begrenzt das Zwischenfrequenzsignal I, Q derart, daß an seinem Ausgang das Zwischenfrequenzsignal I, Q wertdiskret, aber noch zeitkontinuierlich vorliegt. Mittels einer Abtasteinheit AE kann das komplexe, wertdiskrete Zwischenfrequenzsignal unter Verwendung einer Abtastfrequenz S F in ein wertdiskretes und zeitdiskretes Signal umgewandelt werden. Dieses ist in einer der Abtasteinrichtung nachgeschalteten, digitalen Demodulatoreinheit DE demodulierbar, so daß am Ausgang der Demodulatoreinheit DE das Eingangssignal in demodulierter Form vorliegt.

Kanalfilter KF, begrenzender Verstärker LIM, Abtasteinrichtung AE sowie digitale Demodulatoreinheit DE sind dabei zur Verarbeitung eines komplexen Zwischenfrequenzsignals I, Q ausgelegt und bilden gemeinsam eine komplexe Bearbeitungseinheit KB.

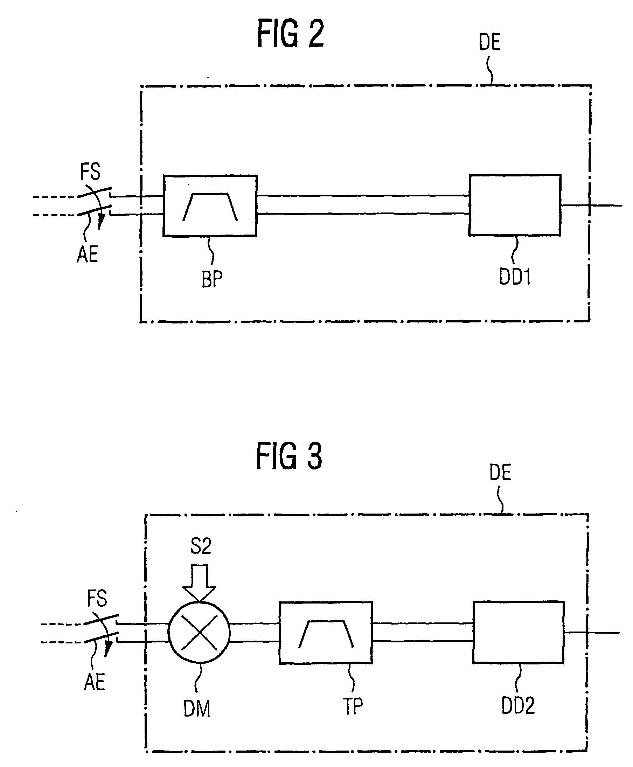

Zur Realisierung der Demodulationseinheit DE sind in den Figuren 2 und 3 beispielhafte alternative Ausführungsmöglichkeiten angegeben.

Bei der digitalen Demodulationseinheit DE gemäß Figur 2 ist der Abtasteinheit AE zur Abtastung des wertdiskreten aber zeitkontinuierlichen Zwischenfrequenzsignals ein Bandpaßfilter BP sowie ein digitaler Demodulator DD1 nachgeschaltet. Das Bandpaßfilter BP ist dabei an seinem Eingang und an seinem Ausgang zur Verarbeitung von in Quadraturkomponenten vorliegenden Signalen geeignet. Das Bandpaßfilter BP dient insbesondere zum Herausfiltern höherer Harmonischer, welche durch das Abtasten des Signals in der Abtasteinrichtung AE auftreten. Der digitale Demodulator DD1, dem eingangsseitig das abgetastete und gefilterte Zwischenfrequenzsignal in seinen Quadraturkomponenten zuführbar ist, weist deshalb zwei Eingänge auf. Der digitale Demodulator DD1 ist als Quadrikorrelator realisiert. Am Ausgang des Quadrikorrelators kann das demodulierte Signal, welches in digitaler Form zeit- und wertdiskret vorliegt, abgeleitet werden.

Figur 3 zeigt ein weiteres Ausführungsbeispiel zur Realisierung der digitalen Demodulationseinheit DE. Dabei ist der Abtasteinrichtung AE, welche das in Quadraturkomponenten zerlegt vorliegende Zwischenfrequenzsignal mit einer Abtastfrequenz S F abtastet, zunächst ein digitaler Mischer DM nachgeschaltet. An seinem zweiten Eingang ist dem digitalen Mischer DM ein zweites Trägersignal S2 zuführbar, dessen Frequenz jeweils so eingestellt ist, daß sie der Mittenfrequenz der Trägerfrequenz des Zwischenfrequenzsignals entspricht, so daß am Ausgang des digitalen Mischers DM ein Basisbandsignal, dessen Trägerfrequenz 0 Hz beträgt, vorliegt. Zweites Trägersignal S2 und das am Ausgang des digitalen Mischers ableitbare Signal weisen jeweils eine Inphase- und eine Quadraturkomponente auf. Während das Bandpaßfilter BP gemäß Figur 2 als komplexes Filter, beispielsweise als Polyphasenfilter, zu realisieren ist, braucht das Tiefpaßfilter gemäß Figur 3 nicht komplex realisiert sein. Das Tiefpaßfilter TP dient insbesondere zum Unterdrücken unerwünschter Signale, welche von Abtasteinheit AE und digitalem Mischer DM verursacht werden. Neben der Aufgabe der Tiefpaßfilterung weist das Tiefpaßfilter TP, welches digital realisiert ist, die Eigenschaft auf, daß es die Taktrate des Signals reduziert (decimation). Dem Tiefpaßfilter ist ein digitaler Demodulator DD2 nachgeschaltet, mit zwei Eingängen zur Zuführung eines komplexen Signals, und mit einem Ausgang, an dem das demodulierte, zeit- und wertdiskrete Eingangssignal vorliegt.

Die beschriebenen Ausführungsbeispiele gemäß Figuren 1 bis 3 sind mit geringem Chipflächenbedarf in einfacher Weise und mit einem hohen Integrationsgrad realisierbar. Darüber hinaus sind sie mit geringer Stromaufnahme betreibbar und weisen eine hohe Genauigkeit und eine hohe Empfindlichkeit auf.

## Patentansprüche

1. Empfängerschaltung zur Demodulation eines Hochfrequenzsignals (RF), insbesondere für den Mobilfunk, aufweisend
- eine erste Mischerstufe (AM), der an einem ersten Eingang das zu demodulierende Hochfrequenzsignal (RF) und an einem zweiten Eingang ein komplexwertiges Trägersignal (S1) zuführbar ist, und an deren Ausgang ein komplexwertiges Zwischenfrequenzsignal (I, Q) ableitbar ist,
- einen rauscharmen Vorverstärker (LNA), über den der erste Eingang der ersten Mischerstufe (AM) an eine Antenne (ANT) angeschlossen ist,
- einen begrenzenden Verstärker (LIM), der an den Ausgang der ersten Mischerstufe (AM) über ein Kanalfilter (KF) angekoppelt ist, welches als Polyphasenfilter ausgebildet ist, und an dessen Ausgang ein aus dem Zwischenfrequenzsignal (I, Q) abgeleitetes, wertdiskretes Signal vorliegt,
- eine Abtasteinrichtung (AE), welche an den Ausgang des begrenzenden Verstärkers (LIM) angeschlossenen ist, und
- eine digitale Demodulationseinheit (DE), die der Abtasteinrichtung (AE) nachgeschaltet ist und die an ihrem Ausgang ein demoduliertes Signal bereitstellt,
- wobei die digitale Demodulationseinheit (DE) entweder ein als Polyphasenfilter ausgeführtes Bandpaßfilter (BP) mit nachgeschaltetem, als Quadrikorrelator ausgeführtem digitalem Demodulator (DD1) aufweist oder die digitale Demodulationseinheit (DE) eine digitale Mischerstufe (DM) mit nachgeschaltetem Tiefpaßfilter (TP) und digitalem Demodulator (DD2) aufweist.

2. Empfängerschaltung nach Anspruch 1,
**dadurch gekennzeichnet,**
**daß** die Frequenz des Zwischenfrequenzsignals (I, Q) kleiner oder gleich 20 MHz ist.

## Claims

1. Receiver circuit for demodulating a radio-frequency signal (RF), in particular for mobile radio, having
- a first mixer stage (AM) that can be fed at a first input the radio-frequency signal (RF) to be demodulated, and at a second input a complex-valued carrier signal (S1), and at whose output a complex-valued intermediate frequency signal (I, Q) can be derived,
- a low-noise preamplifier (LNA), via which the first input of the first mixer stage (AM) is connected to an antenna (ANT),
- a limiting amplifier (LIM) that is coupled to the output of the first mixer stage (AM) via a channel filter (KF) that is designed as a polyphase filter and at whose output a value-discrete signal derived from the intermediate frequency signal (I, Q) is present,
- a sampling device (AE) that is connected to the output of the limiting amplifier (LIM), and
- a digital demodulation unit (DE) that is connected downstream of the sampling device (AE) and which provides a demodulated signal at its output,
- the digital demodulation unit (DE) either having a bandpass filter (BP), designed as a polyphase filter, with a downstream digital demodulator (DD1) designed as a quadricorrelation, or having a digital mixer stage (DM) with a downstream lowpass filter (TP) and digital demodulator (DD2).

2. Receiver circuit according to Claim 1, **characterized in that** the frequency of the intermediate frequency signal (I, Q) is less than or equal to 20 MHz.

## Revendications

1. Circuit récepteur pour la démodulation d'un signal à haute fréquence (RF), notamment pour la radiocommunication mobile, comportant :
- un premier étage mélangeur (AM), auquel peut être envoyé à une première entrée le signal à haute fréquence (RF) à démoduler et à une deuxième entrée un signal porteur à valeurs complexes (S1) et à la sortie duquel peut être déduit un signal à fréquence intermédiaire (I, Q) à valeurs complexes,
- un préamplificateur à faible bruit (LNA), par l'intermédiaire duquel la première entrée du premier étage mélangeur (AM) est raccordée à une antenne (ANT),
- un amplificateur limitant (LIM), qui est raccordé à la sortie du premier étage mélangeur (AM) par l'intermédiaire d'un filtre de canal (KF), conçu comme un filtre polyphasé, et à la sortie duquel se trouve un signal à valeurs discrètes déduit du signal à fréquence intermédiaire (I, Q),
- un dispositif d'échantillonnage (AE), qui est raccordé à la sortie de l'amplificateur limitant (LIM), et
- une unité de démodulation numérique (DE), qui est branchée du côté aval du dispositif d'échantillonnage (AE) et qui fournit à sa sortie un signal démodulé,
- l'unité de démodulation numérique (DE) comportant un filtre passe-bande (BP) conçu comme un filtre polyphasé avec un démodulateur numérique (DD1) branché du côté aval et conçu comme un quadricorrélateur ou l'unité de démodulation numérique (DE) comportant un étage mélangeur numérique (DM) avec un filtre passe-bas (TP) branché du côté aval et avec un démodulateur numérique (DD2) branché du côté aval.

2. Circuit récepteur selon la revendication 1,
**caractérisé par le fait que** la fréquence du signal à fréquence intermédiaire (I, Q) est inférieure ou égale à 20 MHz.
